# EUROPÄISCHE PATENTSCHRIFT

(11) **EP 1 533 903 B1**
(45) Veröffentlichungstag und Bekanntmachung des Hinweises auf die Patenterteilung: **20.02.2008**
(21) Anmeldenummer: 04024121.8
(22) Anmeldetag: 09.10.2004
(51) Int. Cl.: H03K 17/61

(54) **Schaltungsanordnung und Verfahren zur potentialgetrennten Übertragung einer Schaltinformation**
Circuit and method for the voltage insulated transmission of switching information
Procédé et dispositif pour la transmission des commutations avec isolation galvanique

(30) Priorität: 19.11.2003 DE 10354067
(43) Veröffentlichungstag der Anmeldung: 25.05.2005
(73) Patentinhaber: SEMIKRON Elektronik GmbH & Co. KG, 90431 Nürnberg (DE)
(72) Erfinder: Nascimento, Jair do, 91077 Dormitz (DE); Backhaus, Klaus Dr., 90768 Fürth (DE)

(56) Entgegenhaltungen:
- EP-A1- 0 268 930
- WO-A-93/11609
- DE-A1- 3 527 130
- DE-A1- 19 534 888
- US-A- 5 900 683

## Beschreibung

Die Erfindung beschreibt eine Schaltungsanordnung sowie ein zugehöriges Verfahren zur sicheren Übertragung einer Schaltinformation von einer ersten Seite einer Schaltungsanordnung zu einer zweiten Seite der Schaltungsanordnung über eine Potentialtrennung hinweg.

Derartige Schaltungsanordnungen finden beispielhaft bei der Ansteuerung von Leistungshalbleiterschaltem in modernen Leistungshalbleitermodulen der Spannungsklassen von mehr als 600V Anwendung. Hierbei werden ausgehend von einem externen Steuerschaltkreis die einzelnen, vorzugsweise in Halbbrückentopologie angeordneten, Leistungshalbleiterschalter angesteuert. Mindestens einer der beiden Leistungshalbleiterschalter einer derartigen Halbbrücke befindet sich auf einem im Vergleich zum externen Steuerschaltkreis unterschiedlichen und / oder variierenden Potential. Zur Übertragung der Schaltsignale von der Primärseite bzw. des externen Steuerschaltkreises auf die Sekundärseite werden in den dazugehörigen Treiberschaltungen beispielhaft Übertrager eingesetzt. Weiterhin muss bei derartigen Schaltungsanordnungen die Sekundärseite mit Energie versorgt werden. Eine weitere Anforderung an derartige Schaltungsanordnungen ist, dass von der Sekundärseite zur Primärseite Fehlersignale übertragen werden können.

Nach dem Stand der Technik werden einzelne Signale mittels diesen zugeordneten einzelnen Übertragern oder anderen die Potentialtrennung überbrückenden Bauteilen wie Optokopplem übertragen. Hierbei kann beispielhaft das Ansteuersignal "Leistungshalbleiterschalter ein" und das Ansteuersignal "Leistungshalbleiterschalter aus" mittels getrennter Übertrager übertragen werden. Gleiches gilt für die Übertragung von Energie bzw. Fehlersignalen wie oben beschrieben. Nachteilig am geschilderten Stand der Technik ist, dass hierbei ein erheblicher Aufwand an Bauteilen notwendig ist.

Die US 5,900,683 offenbart die Übertragung beider Zustände des Ansteuersignals mittels eines Übertragers. Hierbei wird eine erste übertragene Frequenz als "Leistungshalbleiterschalter ein" und eine zweite übertragene Frequenz als "Leistungshalbleiterschalter aus" auf der Sekundärseite interpretiert. Nachteilig ist hierbei, dass eine Fehlerrückmeldung mittels dieser Schaltungsanordnung nicht möglich ist.

Die vorliegende Erfindung hat die Aufgabe eine flexibel erweiterbare Schaltungsanordnung sowie ein zugehöriges ebenso flexibel erweiterbares Verfahren zur sicheren Übertragung einer Schaltinformation von einer ersten Seite der Schaltungsanordnung zu einer zweiten Seite der Schaltungsanordnung über eine Potentialtrennung hinweg vorzustellen.

Die beiden Teile der Aufgabe werden gelöst durch eine Schaltungsanordnung mit den Merkmalen des Anspruchs 1 sowie durch ein Verfahren nach Anspruch 2. Bevorzugte Weiterbildungen finden sich in den Unteransprüchen.

Der Grundgedanke der erfindungsgemäßen Schaltungsanordnung zur Übertragung einer Schaltinformation über eine Potentialtrennung hinweg basiert auf der Ausgestaltung eines Übertragers, wobei auf dessen Primärseite nicht wie aus dem Stand der Technik bekannt eine, sondern zwei Wicklungen angeordnet sind. Diese beiden Wicklungen sind seriell miteinander verbunden und weisen weiterhin eine Mittelanzapfung auf.

Das Eingangsschaltsignal zur beispielhaften Steuerung eines Leistungshalbleiterschalters liegt auf der ersten Seite, der Primärseite, der Schaltungsanordnung an. Es wird beispielhaft durch einen externen Steuerschaltkreis gebildet. In der erfindungsgemäßen Schaltungsanordnung wird dieses Eingangsschaltsignal in zwei Pfade aufgeteilt, wovon der erste Pfad einen ersten bidirektionalen Schalter ansteuert und der zweite Pfad nach einer Invertierung des Eingangsschaltsignals einen zweiten bidirektionalen Schalter ansteuert.

Ein erster Pol einer Wechselspannungsquelle, vorzugsweise mit einem rechteckförmigen Ausgangssignal, ist mit der ersten Wicklung der Primärseite des Übertragers verbunden. Die Mittelanzapfung zwischen dieser ersten und der zweiten Wicklung ist mit dem ersten Schalter verbunden und dieser ist wiederum mit dem zweiten Pol der Spannungsquelle verbunden. Die zweite Wicklung der Primärseite des Übertragers ist mit dem zweiten Schalter verbunden und dieser ist ebenfalls mit dem zweiten Pol der Spannungsquelle verbunden.

Die Sekundärseite des Übertragers weist eine Wicklung auf, welche vorzugsweise mit den Eingängen eines Gleichrichters auf der zweiten Seite, der Sekundärseite, der Schaltungsanordnung verbunden ist. Der positive Ausgang des Gleichrichters bildet das Ausgangsschaltsignal.

Die Funktionsweise einer oben genannten Schaltungsanordnung wird in der folgenden Beschreibung des Verfahrens zur Übertragung einer Schaltinformation über eine Potentialtrennung hinweg dargelegt. Das von einem externen Steuerschaltkreis gebildete vorzugsweise digitale Eingangsschaltsignal wird in zwei Pfade aufgeteilt. Der erste Pfad steuert einen ersten bidirektionalen Schalter, der zweite Pfad steuert mit dem invertierten Signal einen zweiten bidirektionalen Schalter an.

Wenn der erste Schalter geschlossen ist, ist der zweite Schalter offen, und die erste Wicklung der Primärseite des Übertragers ist mit den beiden Polen der Wechselspannungsquelle verbunden. Die zweite Wicklung ist hierbei nicht stromdurchflossen. Wenn der zweite Schalter geschlossen ist, ist der erste Schalter offen, und die Serienschaltung aus der ersten und der zweiten Wicklung der Primärseite eines Übertragers ist mit den Polen der Wechselspannungsquelle verbunden. Auf der Sekundärseite der Schaltungsanordnung wird die Ausgangswechselspannung aus der sekundärseitigen Wicklung des Übertragers mittels eines Gleichrichters in eine Gleichspannung gewandelt.

Ein geschlossener erster Schalter bewirkt nun abhängig vom Verhältnis der Wicklungszahlen der ersten primären Wicklung und der sekundären Wicklung eine erste Wechselspannung mit einer ersten Amplitude an den Ausgängen der sekundären Wicklung bzw. einen ersten Gleichspannungswert am Ausgang des Gleichrichters. Dies entspricht vorteilhafterweise dem Ansteuersignal "Leistungshalbleiterschalter ein". Ein geschlossener zweiter Schalter bewirkt nun abhängig vom Verhältnis der Summe der Wicklungszahlen der ersten und zweiten primären Wicklungen und der Wicklungszahl der sekundären Wicklung eine zweite Wechselspannung mit einer zweiten Amplitude an den Ausgängen der sekundären Wicklung bzw. einen zweiten Gleichspannungswert am Ausgang des Gleichrichters. Dies entspricht vorteilhafterweise dem Ansteuersignal "Leistungshalbleiterschalter aus".

Je nach Eingangsschaltsignal weist der Ausgang der sekundären Wicklung des Übertragers eine unterschiedliche Amplitude auf, ebenso weist der Gleichspannungswert nach dem Gleichrichter unterschiedliche Werte der Spannung auf. Diese unterschiedliche Amplitude bzw. der unterschiedliche Spannungswert dienen als Ausgangsschaltsignal und steuern beispielhaft die beiden Schaltzustände eines Leistungshalbleiterschalters.

Vorteilhaft an der erfindungsgemäßen Schaltungsanordnung ist, dass durch die gegebene Ausgestaltung neben einer Schaltinformation zusätzlich auch Energie von der Primärseite auf die Sekundärseite übertragen werden kann, ohne die beschriebene Schaltungsanordnung zu verändern. Hierzu wird der Ausgang des Gleichrichters beispielhaft mit einem Aufwärtswandler in eine konstante Versorgungsspannung gewandelt. Das Ausgangsschaltsignal wird hierbei selbstverständlich vor diesem Aufwärtswandler abgegriffen.

Weiterhin vorteilhaft ist, dass die Schaltungsanordnung zur Übertragung eines Fehlersignals von der Sekundärseite zur Primärseite dienen kann. Hierzu wird auf der Sekundärseite ein durch ein dort anliegendes Fehlersignal gesteuerter Schalter zwischen die Ausgänge des Gleichrichters geschaltet. Weiterhin wird auf der Primärseite die zweite Wicklung des Übertragers mit dem Eingang einer Schwellwertdetektorschaltung verbunden. Der Ausgang der Schwellwertdetektorschaltung wird invertiert an den zweiten Eingang eines UND- Gatters angelegt. Dessen ersten Eingang bildet das Eingangsschaltsignal. Der Ausgang des UND- Gatters steuert wie vorgenannt die beiden bidirektionalen Schalter an.

Das Fehlersignal schließt auf der Sekundärseite mittels des dortigen Schalters die sekundärseitige Wicklung des Übertrages kurz. Dies bewirkt auf der Primärseite einen Spannungseinbruch über den beiden Wicklungen. Dieser Spannungseinbruch wird mittels der Schwellwertdetektorschaltung detektiert und hieraus wird ein primärseitiges Fehlersignal gebildet. Das Fehlersignal wird an den externen Steuerschaltkreis sowie invertiert an das UND- Gatter angelegt. Ein Eingangsschaltsignal "Leistungshalbleiterschalter ein" kann das UND- Gatter nur als solches passieren, wenn das primärseitige Fehlersignal "LOW" Pegel aufweist.

Nachfolgend werden die Merkmale und Ausgestaltungen der Erfindung anhand der Fig. 1 bis 5 beispielhaft erläutert.
- Fig. 1: zeigt eine Ausgestaltung einer erfindungsgemäßen Schaltungsanordnung.
- Fig. 2: zeigt eine erweiterte Ausgestaltung der erfindungsgemäßen Schaltungsanordnung nach Fig. 1 mit Ausgangsbeschaltung.
- Fig. 3: zeigt ebenfalls eine erweiterte Ausgestaltung der erfindungsgemäßen Schaltungsanordnung nach Fig. 1 mit Fehlerrückmeldungsschaltung.
- Fig. 4: zeigt die Pegel verschiedener Signale der erfindungsgemäßen Schaltungsanordnung im Normalbetrieb.
- Fig. 5: zeigt die Pegel verschiedener Signale der erfindungsgemäßen Schaltungsanordnung im Fehlerfall.

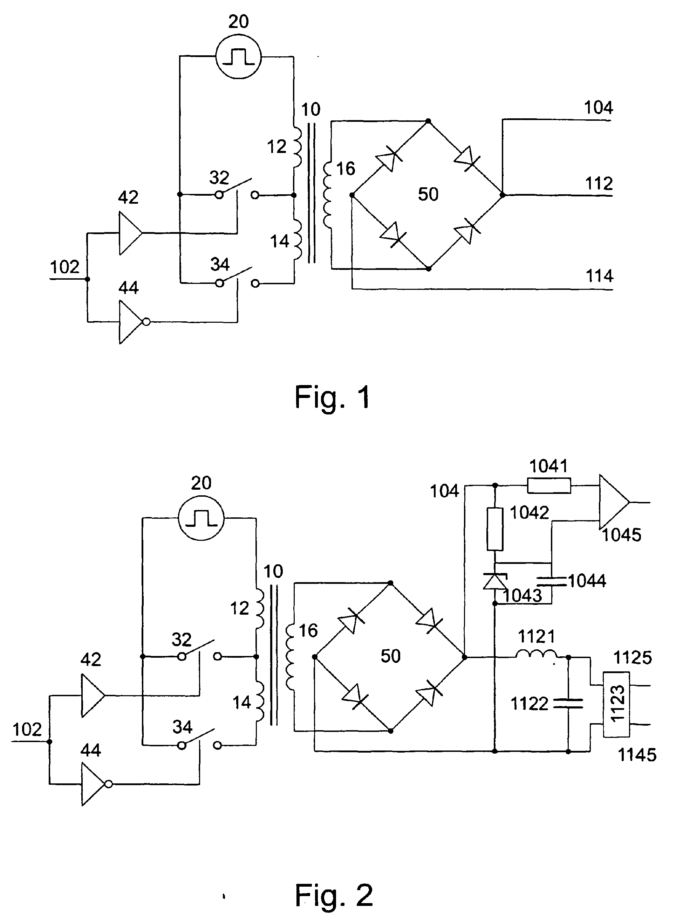

Fig. 1 zeigt eine Ausgestaltung einer erfindungsgemäßen Schaltungsanordnung. Dargestellt ist ein Übertrager (10), wobei auf dessen Primärseite zwei Wicklungen (12, 14) vorgesehen sind. Diese beiden Wicklungen sind seriell miteinander verbunden und weisen eine Mittelanzapfung auf. Der Übertrager zur Übertragung einer Schaltinformation über eine Potentialtrennung hinweg weist weiterhin eine sekundärseitige Wicklung (16) auf.

Das Eingangsschaltsignal (102) der Schaltungsanordnung zur Steuerung eines Leistungshalbleiterschalters in einem nicht dargestellten Leistungshalbleitermodul liegt an der Primärseite der Schaltungsanordnung an. Dieses Eingangsschaltsignal (102) ist in zwei Pfade aufgeteilt, wobei es im ersten Pfad mittels eines ersten Puffer- ICs (42) einen ersten bidirektionalen Schalter (32) ansteuert und im zweiten Pfad nach einer Invertierung in einem zweiten Puffer- IC (44) einen zweiten bidirektionalen Schalter (34) ansteuert. Die bidirektionalen Schalter sind jeweils als eine Parallelschaltung je eines n- Kanal und eines p-Kanal MOS-FETs ausgebildet. Ein geschlossener erster Schalter (32) entspricht einem "HIGH" Pegel des Eingangsschaltsignals (102), ein geschlossener zweiter Schalter (34) entspricht einem "LOW" Pegel des Eingangsschaltsignals (102).

Ein erster Pol einer Wechselspannungsquelle (20) mit einem rechteckförmigen Ausgangssignal ist mit der ersten Wicklung (12) der Primärseite des Übertragers (10) verbunden. Die Mittelanzapfung zwischen dieser ersten (12) und der zweiten Wicklung (14) ist mit dem ersten Schalter (32) verbunden und dieser ist wiederum mit dem zweiten Pol der Spannungsquelle (20) verbunden. Die zweite Wicklung (14) der Primärseite des Übertragers (10) ist mit dem zweiten Schalter (34) verbunden und dieser ist ebenfalls mit dem zweiten Pol der Spannungsquelle (20) verbunden.

Die Sekundärseite des Übertragers (10) weist eine Wicklung (16) auf, welche mit den Eingängen eines Gleichrichters (50) auf der Sekundärseite der Schaltungsanordnung verbunden ist. Der erste Ausgang des Gleichrichters bildet das Ausgangsschaltsignal (104).

Wenn der erste Schalter (32) geschlossen und damit der zweite Schalter (34) offen ist, ist ausschließlich die erste Wicklung (12) der Primärseite des Übertragers (10) stromdurchflossen. Somit wird abhängig von dem Verhältnis der Wicklungszahlen der ersten primären Wicklung (12) und der sekundären Wicklung (16) eine erste Wechselspannung mit einer ersten Amplitude an den Ausgängen der sekundären Wicklung bzw. eine erster Gleichspannungswert am Ausgang des Gleichrichters (50) erzeugt.

Wenn der zweite Schalter (34) geschlossen und damit der erste Schalter offen (32) ist, sind die erste (12) und die zweite Wicklung (14) der Primärseite des Übertragers (10) stromdurchflossen. Somit wird abhängig von dem Verhältnis der Summe der Wicklungszahlen der ersten (12) und zweiten Wicklung (14) und der Wicklungszahl der sekundären Wicklung (16) eine zweite Wechselspannung mit einer zweiten, kleineren Amplitude an den Ausgängen der sekundären Wicklung bzw. ein zweiter, geringerer Gleichspannungswert am Ausgang des Gleichrichters (50) erzeugt.

Fig. 2 zeigt eine erweiterte Ausgestaltung der erfindungsgemäßen Schaltungsanordnung nach Fig. 1 mit Ausgangsbeschaltung. Diese Ausgangsbeschaltung dient einerseits zur Detektion des Ausgangsschaltsignals (104) und andererseits zur Bildung einer Spannungsversorgung der Sekundärseite.

Zur Detektion des zu übertragenden Schaltzustandes wird das Ausgangsschaltsignal (104) über einen Widerstand (1041) an den ersten Eingang eines Komparators (1045) angelegt. Weiterhin wird das Ausgangsschaltsignal (104) über den Mittelpunkt eines Spannungsteilers, gebildet aus einem Widerstand (1042) und einer Zenerdiode (1043) mit parallel geschaltetem Kondensator (1044), an den zweiten Eingang des Komparators (1045) angelegt. Dieser Pfad bildet eine Referenzspannung, mittels derer der Wert des Ausgangssignals (104) bestimmt werden kann. Liegt der Wert des Ausgangssignals (104) unterhalb der Schwelle, Schalter (34) ist geschlossen, liegt am Ausgang des Komparators (1045) "LOW" Pegel an und der nachgeordnete Leistungshalbleiterschalter ist offen. Liegt der Wert des Ausgangssignals (104) oberhalb der Schwelle, Schalter (32) ist geschlossen, ist der nachgeordnete Leistungshalbleiterschalter geschlossen.

Zur Spannungsversorgung von weiteren Bauelementen und Schaltungen, wie die Versorgung der Gates der Leistungshalbleiterbauelemente, der Sekundärseite dient der Aufwärtswandler (1123), vor dessen Eingänge noch ein Kondensator (1122) zur Glättung und eine Spule (1121) geschaltet ist. Die Spule (1121) dient hier der Entkopplung des Ausgangsschaltsignals (104) von den Eingängen des Aufwärtswandler (1123). Die Ausgänge des Aufwärtswandlers (1123) stellen somit eine Spannungsquelle mit konstanter Gleichspannung dar.

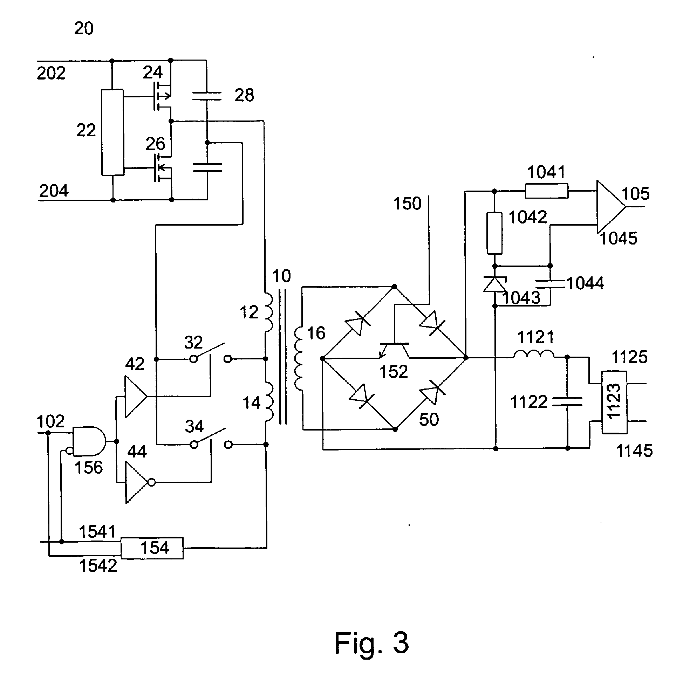

Fig. 3 zeigt ebenfalls eine erweiterte Ausgestaltung der erfindungsgemäßen Schaltungsanordnung nach Fig. 1 mit Fehlerrückmeldungsschaltung sowie einer Ausgestaltung der Wechselspannungsquelle (20). Die Wechselspannungsquelle (20) besteht aus zwei Gleichspannungseingängen (202, 204) an einem Oszillator (22), der eine aus den Gleichspannungseingängen versorgte Halbbrückenanordnung von zwei MOS- FETs (24, 26) ansteuert. Deren Mittelabgriff bildet einen ersten Pol der Wechselspannungsquelle. Weiterhin sind zwei seriell geschaltete Kondensatoren (28) ebenfalls mit den Gleichspannungseingängen (202, 204) verbunden. Deren Mittelabgriff bildet den zweiten Pol der Wechselspannungsquelle. Diese Schaltung erzeugt an ihren Polen eine rechteckförmige Wechselspannung einer am Oszillator (22) einstellbaren Frequenz.

Zur Fehlerrückmeldung von der Sekundär- zur Primärseite der Schaltungsanordnung weist der Gleichrichter (50) auf der Sekundärseite einen Schalter (152) zur Verbindung seiner beiden Ausgänge miteinander auf. Dieser Schalter (152) wird durch das Fehlersignal (150) angesteuert. Auf der Primärseite ist die zweite Wicklung (14) des Übertragers mit dem Eingang einer Schwellwertdetektorschaltung (154) verbunden. Diese Schwellwertdetektorschaltung (154) weist weiterhin einen Synchronisationseingang (1542) auf, der mit dem Eingangssteuersignal (102) verbunden ist. Der Ausgang, ein primärseitiges Fehlersignal (1541), ist sowohl mit dem externen Steuerschaltkreis als auch mit dem zweiten Eingang eines UND- Gatters (156) verbunden. Vor diesem Eingang wird das Fehlersignal invertiert. Den ersten Eingang des UND- Gatters (156) bildet das Eingangssteuersignal (102) selbst. Der Ausgang des UND- Gatters wird wie unter Fig. 1 beschrieben in zwei Pfade aufgeteilt und steuert die beiden bidirektionalen Schalter (32, 34) an.

Ein Fehlersignal (150) schließt den Schalter (152) zwischen den beiden Ausgängen des Gleichrichters (50), wodurch die Sekundärwicklung (16) kurzgeschlossen wird. Dieser Kurzschluss der Sekundärwicklung (16) führt auf der Primärseite zu einer Spannungsreduktion, die durch eine Schwellwertschaltung (154) detektiert wird. Somit wird ein Fehlersignal (150) von der Sekundär- zur Primärseite übertragen. Die Schwellwertschaltung (154) weist einen Synchronisationseingang (1542) auf, der mit dem Eingangssteuersignal (102) verbunden ist. Somit erzeugt die Schaltung nur dann ein Fehlersignal wenn ein Ansteuersignal "Leistungshalbleiterschalter ein" anliegt. Da das Fehlersignal invertiert auf dem zweiten Eingang des UND- Gatters (156) liegt, kann ein Ansteuersignal "Leistungshalbleiterschalter ein" dieses UND- Gatter (156) nur passieren, wenn kein Fehler auf der Sekundärseite vorliegt, dort also der Schalter (152) offen ist.

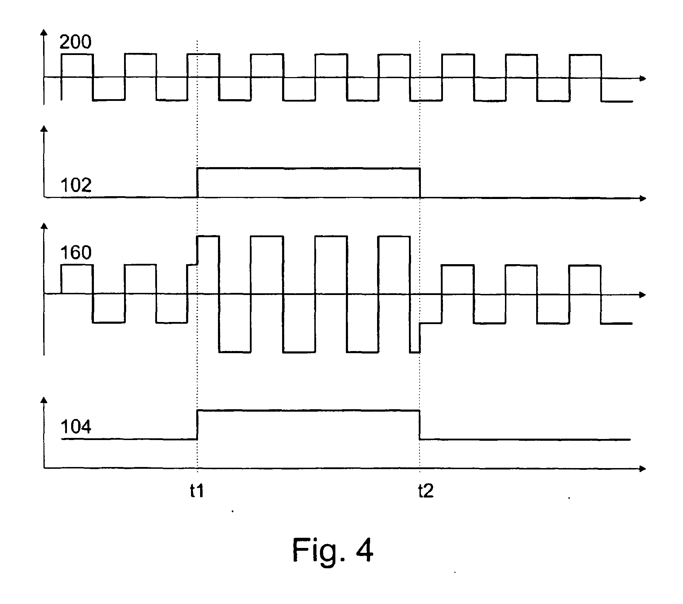

Fig. 4 zeigt die Pegel verschiedener Signale der erfindungsgemäßen Schaltungsanordnung im Normalbetrieb. Das Signal (200) ist das von der Wechselspannungsquelle (20) erzeugte Rechtecksignal. Zu einem beliebigen Zeitpunkt (t1) wird das Eingangssteuersignal (102) von LOW- Pegel ("Leistungshalbleiterschalter aus") auf HIGH Pegel ("Leistungshalbleiterschalter ein") gelegt. Bis zu diesem Zeitpunkt weist die in der sekundärseitigen Wicklung (16) induzierte Spannung (160) einen ersten Wert der Amplitude auf, da beide primärseitigen Wicklungen (12, 14) stromdurchflossen sind.

Der Wechsel des Ansteuersignals (102) auf HIGH- Pegel bewirkt, dass nur mehr die erste Wicklung (12) stromdurchflossen ist. Durch die nun geringere Anzahl der stromdurchflossenen Wicklungen auf der Primärseite steigt auf der Sekundärseite die Amplitude der induzierten Spannung (160) durch die zugeordnete Wicklung (16). Diese größere Amplitude wird mittels des Gleichrichters (50) in ein Ausgangssteuersignal (104) gewandelt, welches ein analoges Verhalten zum Eingangssteuersignal (102) aufweist. Ein Wechsel zum Zeitpunkt (t2) zurück zu einen LOW- Pegel des Eingangssteuersignals (102) bewirkt ein analoges Verhalten des Ausgangssteuersignals (104).

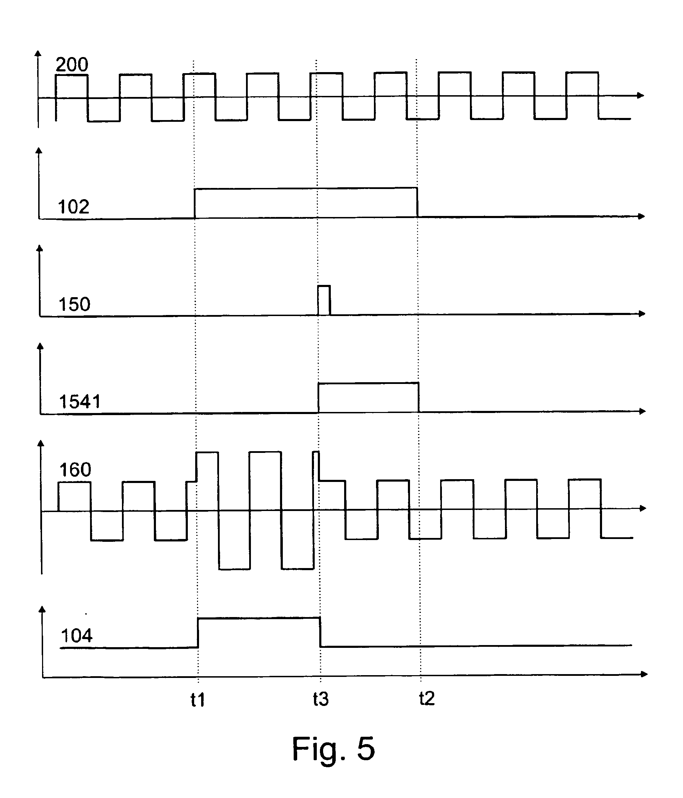

Fig. 5 zeigt die Pegel verschiedener Signal der erfindungsgemäßen Schaltungsanordnung im Fehlerfall. Das Signal (200) ist wiederum das von der Wechselspannungsquelle (20) erzeugte Rechtecksignal. Zu einem beliebigen Zeitpunkt (t1) wird das Eingangssteuersignal (102) von LOW- Pegel ("Leistungshalbleiterschalter aus") auf HIGH Pegel ("Leistungshalbleiterschalter ein") gelegt und zu einem späteren Zeitpunkt (t2) wieder auf LOW- Pegel zurück. Zu einem Zeitpunkt (t3) tritt nun auf der Sekundärseite ein Fehlersignal (150) auf, das den zugehörigen Schalter (152) schließt. Nach der Übertragung auf die Primärseite und die Detektion in der Schwellwertschaltung (154) erzeugt diese ein primärseitiges Fehlersignal (1541). Dieses besteht auf Grund der Synchronisation der Schwellwertschaltung (154) mit dem Eingangssteuersignal (150) so lange bis das Eingangssteuersignal (102) nicht mehr anliegt, unabhängig davon ob das sekundärseitige Fehlersignal (150) noch anliegt.

Die Amplitude der in der sekundärseitigen Wicklung (16) induzierte Spannung (160) weist bis zum Zeitpunkt (t1) einen ersten Wert auf. Zur Zeitpunkt (t1) an dem das Eingangssteuersignal von LOW auf HIGH- Pegel wechselt, wechselt auch die Amplitude (16) ihren Wert. Bei Einsetzen des Fehlersignals zum Zeitpunkt (t3) wechselt die Amplitude auf den geringeren Wert zurück, da der zweite Eingang des UND- Gatter ab diesem Zeitpunkt nach seiner Invertierung einen LOW- Pegel aufweist. Das Ausgangssteuersignal wechselt also ab dem Zeitpunkt (t3) auf den Wert der "Leistungshalbleiterschalter aus" entspricht. Somit ist eine Schutzfunktion des Leistungshalbleiterschalter gegeben.

## Patentansprüche

1. Schaltungsanordnung zur Übertragung einer Schaltinformation über eine Potentialtrennung hinweg, wobei ein Eingangsschaltsignal (102) auf der ersten Seite, der Primärseite der Schaltungsanordnung in zwei Pfade aufgeteilt ist, in einen ersten Pfad zur Ansteuerung eines ersten bidirektionalen Schalters (32) und in einen zweiten Pfad nach einer Invertierung des Eingangsschaltsignals zur Ansteuerung eines zweiten bidirektionalen Schalters (34), wobei
eine Wechselspannungsquelle (20) mit einem ersten Pol mit einer ersten Wicklung (12) der Primärseite eines Übertragers (10) verbunden ist, diese erste Wicklung (12) weiterhin über eine Mittelanzapfung der Primärseite des Übertragers mit einer zweiten Wicklung (14) des Übertragers (10) verbunden ist und
die Mittelanzapfung weiterhin mit dem ersten Schalter (32) und dieser wiederum mit dem zweiten Pol der Spannungsquelle (20) verbunden ist,
sowie die zweite Wicklung (14) mit ihrem nicht mit der Mittelanzapfung verbundenen Ende mit dem zweiten Schalter (34) und dieser ebenfalls mit dem zweiten Pol der Spannungsquelle (20) verbunden ist und
die Sekundärseite des Übertragers eine Wicklung (16) aufweist, welche mit den Eingängen eines Gleichrichters (50) auf der Sekundärseite der Schaltungsanordnung verbunden ist, dessen positiver Ausgang das Ausgangsschaltsignal (104) bildet.

2. Verfahren zur Übertragung einer in einem Eingangsschaltsignal (102) enthaltenen Schaltinformation über eine Potentialtrennung hinweg, mit einer primärseitigen Wechselspannungsversorgung (20) eines Übertragers (10) wobei das Eingangsschaltsignal (102) zwei mögliche Schaltzustande aufweist und wobei dem ersten Schaltzustand eine erste Anzahl von Wicklungen der Primärseite eines Übertragers und dem zweiten Schaltzustand eine zweite von der ersten unterschiedliche Anzahl von Wicklungen auf der Primärseite eines Übertragers zugeordnet ist und somit auf der Sekundärseite je nach Schaltinformation ein unterschiedlicher Wert der Spannung in der dortigen Wicklung (16) des Übertragers (10) induziert wird und aus diesen unterschiedlichen Werten der Spannung die beiden Schaltzustände das Ausgangssteuersignals (104) erzeugt werden.

3. Schaltungsanordnung nach Anspruch 1, wobei
das Ausgangsschaltsignal (104) über einen Widerstand (1041) an den ersten Eingang eines Komparators (1045) angelegt wird und über den Mittelpunkt eines Spannungsteilers, gebildet aus einem Widerstand (1042) und einer Zenerdiode (1043) mit parallel geschaltetem Kondensator (1044), an den zweiten Eingang des Komparators (1045) angelegt wird.

4. Schaltungsanordnung nach Anspruch 1, wobei
die Ausgänge des Gleichrichters (50) geglättet und mit den Eingängen eines Aufwärtswandler (1123) verbunden sind.

5. Schaltungsanordnung nach Anspruch 1, wobei
die Ausgänge des Gleichrichters (50) auf der Sekundärseite mittels eines Schalters (152) verbunden sind und auf der Primärseite die zweite Wicklung (14) des Übertragers (10) mit dem ersten Eingang einer Schwellwertdetektorschaltung (154) verbunden ist und deren Ausgang mit dem zweiten Eingang eines UND- Gatters (156) verbunden ist, dessen erster Eingang mit dem Eingangsschaltsignal (102) verbunden ist und dessen Ausgang mit den beiden bidirektionalen Schaltern (32, 34) verbunden ist.

6. Schaltungsanordnung nach Anspruch 1, wobei
die bidirektionalen Schalter (32, 34) als je eine Parallelschaltung je eines n- Kanal und eines p- Kanal MOS- FETs ausgebildet sind.

7. Verfahren nach Anspruch 2, wobei
die Ausgangsspannung (160) auf der Sekundärseite des Übertragers (10) mittels eines Gleichrichters (50) gleichgerichtet wird und mittels eines Schalters (152) zwischen den beiden Ausgängen des Gleichrichters (50) die Sekundärwicklung (16) kurzgeschlossen werden kann um dadurch auf der Primärseite an der Wicklung (14) des Übertragers (10) eine Spannungsreduktion zu bewirken, die durch eine Schwellwertschaltung (154) detektiert wird und somit ein Fehlersignal (1541) von der Sekundär- zur Primärseite übertragen wird.

8. Verfahren nach Anspruch 2, wobei
die von der Primärseite zur Sekundärseite der Schaltungsanordnung übertragene Leistung als Spannungsversorgung sekundärseitiger Bauelementen und Schaltungen dient und hierzu die Ausgangsspannung eines Gleichrichters (50) am Ausgang der Wicklung (16) der Sekundärseite des Übertragers mittels eines Aufwärtswandlers (1123) in eine konstante Gleichspannung gewandelt wird.

## Claims

1. A circuit configuration for transferring switching information across a potential separation, wherein, on the first side, the primary side of the circuit configuration, an input switching signal (102) is divided into two paths, into a first path for activating a first bidirectional switch (32) and into a second path after an inversion of the input switching signal for activating a second bidirectional switch (34), wherein
an alternating voltage source (20) comprising a first pole is connected with a first winding (12) of the primary side of a transformer (10), said first winding (12) is furthermore connected with a second winding (14) of the transformer (10) via a center tapping of the primary side of the transformer and wherein the center tapping is furthermore connected with the first switch (32) and said first switch (32), in turn, is connected with the second pole of the voltage source (20),
and the second winding (14), with its end; which is not connected with the center tapping, is connected with the second switch (34) and said second switch (34) is also connected with the second pole of the voltage source (20) and
the secondary side of the transformer encompasses a winding (16), which is connected with the inputs of a rectifier (50) on the secondary side of the circuit configuration, the positive output of which forms the output switching signal (104).

2. A method for transferring switching information included in an input switching signal (102) across a potential separation, comprising an alternating voltage supply (20) of a transformer (10) on the primary side, wherein the input switching signal (102) encompasses two possible switching states and wherein a first number of windings of the primary side of a transformer is assigned to the first switching state and a second number of windings on the primary side of a transformer, which is different from the first number, is assigned to the second switching state and thus, depending on the switching information, a different value of the voltage is induced on the secondary side in the winding (16) of the transformer (10) located there and the two switching states of the output control signal (104) are created from these different values of the voltage.

3. The circuit configuration according to claim 1, wherein
the output switching signal (104) is applied to the first input of a comparator (1045) via a resistor (1041) and is applied to the second input of the comparator (1045) via the center of a voltage divider, formed from a resistor (1042) and a Zener diode (1043) comprising a capacitor (1044), which is connected in parallel.

4. The circuit configuration according to claim 1, wherein
the outputs of the rectifier (50) are smoothed and are connected with the inputs of a boost converter (1123).

5. The circuit configuration according to claim 1, wherein
the outputs of the rectifier (50) are connected by means of a switch (152) on the secondary side and the second winding (14) of the transformer (10) is connected with the first input of a threshold value detector circuit (154) on the primary side, and the output of said threshold value detector circuit (154) is connected with the second input of an UND gate (156), the first input of which is connected with the input switching signal (102) and the output of which is connected with the two bidirectional switches (32, 34).

6. The circuit configuration according to claim 1, wherein
the bidirectional switches (32, 34) are embodied in each case as a parallel circuit of a respective n-channel and of a p-channel MOSFET.

7. The method according to claim 2, wherein
the output voltage (160) on the secondary side of the transformer (10) is rectified by means of a rectifier (50) and the secondary winding (16) can be shortcircuited between the two outputs of the rectifier (50) by means of a switch (152) so as to thus cause, on the primary side at the winding (14) of the transformer (10), a voltage reduction, which is detected by means of a threshold value circuit (154) and an error signal (1541) is thus transferred from the secondary side to the primary side.

8. The method according to claim 2, wherein
the power transferred from the primary side to the secondary side of the circuit configuration serves as a voltage supply of components and circuits on the secondary side, and for this purpose, the output voltage of a rectifier (50) at the output of the winding (16) of the secondary side of the transformer is changed into a constant direct voltage by means of a boost converter (1123).

## Revendications

1. Circuit pour la transmission d'une information de commutation par-delà une séparation de potentiel,
- un signal de commutation d'entrée (102) du premier côté, le côté primaire, du circuit étant divisé en deux voies, une première voie pour la commande d'un premier interrupteur bidirectionnel (32) et une deuxième voie après une inversion du signal de commutation d'entrée pour la commande d'un deuxième interrupteur bidirectionnel (34),
- une source de tension alternative (20) étant reliée par un premier pôle à un premier enroulement (12) du côté primaire d'un transformateur (10), ce premier enroulement (12) étant aussi relié par l'intermédiaire d'une prise médiane du côté primaire du transformateur à un deuxième enroulement (14) du transformateur (10) et la prise médiane étant aussi reliée au premier interrupteur (32) et celui-ci étant relié au deuxième pôle de la source de tension (20),
- le deuxième enroulement (14) étant relié par son extrémité qui n'est pas reliée à la prise médiane au deuxième interrupteur (34) et celui-ci étant également relié au deuxième pôle de la source de tension (20), et
- le côté secondaire du transformateur comportant un enroulement (16) qui est relié aux entrées d'un redresseur (50), du côté secondaire du circuit, dont la sortie positive constitue le signal de commutation de sortie (104).

2. Procédé pour la transmission d'une information de commutation contenue dans un signal de commutation d'entrée (102) par-delà une séparation de potentiel, avec une alimentation en tension alternative côté primaire (20) d'un transformateur (10), le signal de commutation d'entrée (102) comportant deux états de commutation possibles, un premier nombre d'enroulements du côté primaire d'un transformateur étant associé au premier état de commutation et un deuxième nombre, différent du premier, d'enroulements du côté primaire d'un transformateur étant associé au deuxième état de commutation, et, selon l'information de commutation, une valeur de tension différente étant induite du côté secondaire dans l'enroulement (16) situé là du transformateur (10) et les deux états de commutation du signal de commande de sortie (104) étant produits à partir de ces différentes valeurs de la tension.

3. Circuit selon la revendication 1, le signal de commutation de sortie (104) étant appliqué par l'intermédiaire d'une résistance (1041) à la première entrée d'un comparateur (1045) et par l'intermédiaire du point médian d'un diviseur de tension, constitué par une résistance (1042) et par une diode Zener (1043) avec un condensateur branché en parallèle (1044), à la deuxième entrée du comparateur (1045).

4. Circuit selon la revendication 1, les sorties du redresseur (50) étant lissées et reliées aux entrées d'un convertisseur élévateur (1123).

5. Circuit selon la revendication 1, les sorties du redresseur (50) du côté secondaire étant reliées au moyen d'un interrupteur (152) et, du côté primaire, le deuxième enroulement (14) du transformateur (10) étant relié à la première entrée d'un circuit détecteur de valeur de seuil (154) et la sortie de celui-ci étant reliée à la deuxième entrée d'une porte ET (156) dont la première entrée est reliée au signal de commutation d'entrée (102) et dont la sortie est reliée aux deux interrupteurs bidirectionnels (32, 34).

6. Circuit selon la revendication 1, les interrupteurs bidirectionnels (32, 34) étant conçus chacun comme un circuit parallèle d'un MOSFET à canal n et d'un MOSFET à canal p.

7. Procédé selon la revendication 2, la tension de sortie (160) du côté secondaire du transformateur (10) étant redressée au moyen d'un redresseur (50) et l'enroulement secondaire (16) pouvant être court-circuité au moyen d'un interrupteur (152) entre les deux sorties du redresseur (50) pour provoquer ainsi du côté primaire sur l'enroulement (14) du transformateur (10) une réduction de tension qui est détectée par un circuit à valeur de seuil (154), un signal d'erreur (1541) étant ainsi transmis du côté secondaire au côté primaire.

8. Procédé selon la revendication 2, la puissance transmise du côté primaire au côté secondaire du circuit servant d'alimentation en tension de composants et circuits côté secondaire et, à cet effet, la tension de sortie d'un redresseur (50) à la sortie de l'enroulement (16) du côté secondaire du transformateur étant convertie au moyen d'un convertisseur élévateur (1123) en une tension continue constante.
